# EUROPÄISCHE PATENTSCHRIFT

(11) **EP 3 232 205 B1**
(45) Veröffentlichungstag und Bekanntmachung des Hinweises auf die Patenterteilung: **17.01.2024**
(21) Anmeldenummer: 16165561.8
(22) Anmeldetag: 15.04.2016
(51) Int. Cl.: G01R 1/067, G01R 1/02

(54) **SYSTEM UMFASSEND TASTKOPF FÜR MESSGERÄT UND TASTKOPFANSCHLUSSEINHEIT**
SYSTEM COMPRISING SENSOR HEAD FOR A MEASURING DEVICE AND SENSOR HEAD CONNECTION UNIT
SYSTÈME COMPRENANT UNE TÊTE DE CAPTEUR POUR UN APPAREIL DE MESURE ET UNE UNITÉ DE CONNEXION DE LA TÊTE DE CAPTEUR

(43) Veröffentlichungstag der Anmeldung: 18.10.2017
(73) Patentinhaber: Rohde & Schwarz GmbH & Co. KG, 81671 München (DE)
(72) Erfinder: Ziegler, Andreas, 91257 Pegnitz (DE)
(74) Vertreter: Isarpatent

(56) Entgegenhaltungen:
- WO-A1-2005/124370
- DE-A1- 3 734 365
- DE-A1-102008 009 962
- JP-A- H11 201 991
- US-A1- 2003 137 310
- US-A1- 2008 278 143
- US-A1- 2013 106 401

## Beschreibung

Die Erfindung betrifft ein System mit einem Tastkopf für ein Messgerät, insbesondere für ein Oszilloskop oder einen Spektrumanalyzer.

Die Druckschrift US 2013/106401 A1 beschreibt ein Tastkopf für eine Oszilloskop mit einer Statusanzeige.

Die Druckschrift US 2003/137310 A1 beschreibt einen LCD-Bildschirm, für eine Testspitze.

Die Druckschrift JP H11-201991 A beschreibt eine Testspitze mit einem Anzeigeelement für eine Messesignal.

Die Druckschrift DE 3734365 A1 beschreibt ein zusätzliches Anzeigeelement für ein digitales Messgerät.

Die Druckschrift US 2008/278143 A1 beschreibt einen entferntes Anzeigeelement für eine Messgerät.

Die Druckschrift DE 10 2008 009962 A1 beschreibt einen Tastkopf mit hochgenauer Gleichspannung Messung, welcher eine erste Übertragungsleitung Übertragung von Breitbandmesssignalen aufweist. Mittels einer weitere Übertragungsleitung kann ein Gleichspannungsmesssignal an das Messgerät übertragen werden.

Die Druckschrift WO 2005/124370 A1 beschreibt eine Sonde zur Erfassung einer physikalischen Eigenschaft, wobei der Messwert kabellos an eine entfernte Anzeige übertragen werden kann.

Elektronische Messgeräte, beispielsweise Oszilloskope, verfügen typischerweise über mehrere Messgeräteeingänge, an die jeweils ein Tastkopf zur Aufnahme eines Messsignals angeschlossen wird. Häufig werden in einer Messanordnung mehrere Tastköpfe zum Abgreifen unterschiedlicher Signale eingesetzt und an mehreren verfügbaren Eingängen des Messgerätes angeschlossen. Der Tastkopf, der auch als Tastteiler bezeichnet wird, stellt ein Messmittel dar. Der Tastkopf führt das Messsignal dem eigentlichen Messgerät, beispielsweise einem Oszilloskop, zu. Tastköpfe können zum Messen unterschiedlicher physikalischer Größen insbesondere zur Messung von Spannungen oder elektrischen Strömen eingesetzt werden.

Herkömmliche Tastköpfe werden über eine Signalleitung mit dem Messgerät verbunden. Der Tastkopf besitzt mindestens eine Messspitze zum Abgreifen des zu messenden Signals, beispielsweise mithilfe einer Prüfspitze oder eines Prüf-Clips. Beim Aufsetzen der Messspitze des Tastkopfes durch den Nutzer wird das Messsignal über eine Messsignalleitung zu dem Messgerät übertragen und dort auf der Anzeigeeinheit dem Nutzer angezeigt. Ein Nachteil herkömmlicher Tastköpfe besteht darin, dass der Nutzer bei der Durchführung der Messung gezwungen ist, auf das mit dem Tastkopf verbundene Messgerät zu blicken, um ein dort ggf. angezeigtes Messsignal auf dem Display des Messgerätes zu erkennen. Dies ist für den Nutzer bzw. Messtechniker relativ unpraktisch und stellt auch ein gewisses Sicherheitsrisiko dar. Wird der Tastkopf von dem Nutzer an gewisse Messpunkte, in einer Schaltung eines Gerätes zum Abgreifen des Messsignals angelegt, kann der manuell gehaltene Messkopf verrutschen, während der Nutzer auf die Anzeigeanzeigeeinheit bzw. das Display des Messgeräts blickt. Es kann in vielen Fällen auch vorkommen, dass der Nutzer bzw. Messtechniker das auf dem Oszilloskop angezeigte Messsignal nicht richtig erkennen kann, da sich das Messgerät in einigem Abstand von dem Tastkopf befindet. Dadurch wird die Messung für den Messtechniker erschwert und dauert entsprechend länger. Weiterhin kann es bei herkömmlichen Tastköpfen vorkommen, dass ein Nutzer bzw. Messtechniker zu spät erkennt, dass die zu messende Leitung eine sicherheitskritische Spannung aufweist. Weist eine Leitung oder ein Messpunkt eine kritische Spannung auf, kann dies der Messtechniker erst erkennen, wenn er auf die Anzeigeeinheit des Messgerätes blickt. Befindet sich das Messgerät mit dem Anzeigegerät bei der Vornahme der Messung nicht direkt in seinem Sichtfeld, kann er daher eine an der zu messenden Stelle bestehende gefährliche Spannung nicht erkennen.

Es ist daher eine Aufgabe der vorliegenden Erfindung, ein System mit einem Tastkopf für ein Messgerät zu schaffen, welcher einerseits die Vornahme von Messungen für einen Nutzer vereinfacht und andererseits die Sicherheit bei der Messung für den Nutzer erhöht.

Diese Aufgabe wird erfindungsgemäß durch ein System mit den im Patentanspruch 1 angegebenen Merkmalen gelöst.

Die Erfindung schafft demnach ein System mit einem Tastkopf und einer Tastkopfanschlusseinheit für ein Messgerät. Der Tastkopf umfasst
mindestens eine Messspitze zur sensorischen Erfassung eines Signals,
mindesten einem Messsignalverstärker zur Signalverstärkung des durch die Messspitze sensorisch erfassten Signals, wobei der Messsignalverstärker das verstärkte Messsignal über mindestens eine Messsignalleitung an eine Tastkopfanschlusseinheit und/oder an ein Messgerät überträgt; und
eine Recheneinheit, die Messwerte des durch die Messspitze erfassten Signals zur Anzeige auf einer Anzeigeeinheit des Tastkopfes aufbereitet.

Die Tastkopfanschlusseinheit des Tastkopfes weist einen Analog/Digital-Wandler auf, der das von dem Messsignalverstärker des Tastkopfes verstärkte und über die Messsignalleistung übertragene Messsignal in digitale Messwerte umwandelt und an eine in der Tastkopfanschlusseinheit enthaltene Recheneinheit ausgibt, welche die Messwerte an die Recheneinheit des Tastkopfes und an das Messgerät überträgt.

Bei einer weiteren möglichen Ausführungsform des erfindungsgemäßen Tastkopfes weist der Tastkopf eine Nutzerschnittstelle für Benutzereingaben eines Nutzers, beispielsweise eines Messtechnikers, auf.

Bei einer weiteren möglichen Ausführungsform des erfindungsgemäßen Systems ist die Anzeigeeinheit ein Touchscreen, das eine Nutzerschnittstelle für die Benutzereingaben eines Nutzers bildet.

Bei einer weiteren möglichen Ausführungsform des erfindungsgemäßen Systems bildet der Tastkopf eine weitere Messspitze zur sensorischen Erfassung eines Referenzpotentials.

Bei einer weiteren möglichen Ausführungsform des erfindungsgemäßen Systems werden die Recheneinheit und/oder die Anzeigeeinheit und/oder der Messsignalverstärker des Tastkopfes über mindestens eine Stromversorgungsleitung von der Tastkopfanschlusseinheit direkt mit Strom versorgt.

Bei einer weiteren möglichen Ausführungsform des erfindungsgemäßen Systems sind die Datenleitungen für die Übertragung der Messwerte, Messsignalleitungen für die Übertragung des sensorisch erfassten und verstärkten Signals sowie Stromversorgungsleitungen zur Stromversorgung der Recheneinheit und/oder zur Stromversorgung des Messsignalverstärkers und/oder zur Stromversorgung der Anzeigeeinheit in einem Messkabel enthalten.

Bei einer weiteren möglichen Ausführungsform des erfindungsgemäßen Systems ist die Datenschnittstelle des Tastkopfes eine bidirektionale Datenschnittstelle zum bidirektionalen Datenaustausch zwischen dem Tastkopf und der daran angeschlossenen Tastkopfanschlusseinheit .

Bei einer weiteren möglichen Ausführungsform des erfindungsgemäßen Systems erhält die Recheneinheit des Tastkopfes über die bidirektionale Datenschnittstelle Betriebszustandsdaten, die einen aktuellen Betriebszustand des angeschlossenen Messgerätes angeben.

Bei einer weiteren möglichen Ausführungsform des erfindungsgemäßen Systems erhält die Recheneinheit des Tastkopfes über die bidirektionale Datenschnittstelle Mitteilungen des Messgerätes, die das Messgerät in Abhängigkeit des über die Messsignalleitungen von dem Tastkopf erhaltenen Messsignals generiert.

Bei einer weiteren möglichen Ausführungsform des erfindungsgemäßen Systems zeigt die Anzeigeeinheit des Tastkopfes neben Messwerten des von der Messspitze des Tastkopfes sensorisch erfassten Signals einen Betriebszustand des angeschlossenen Messgerätes und/oder eine erhaltene Mitteilung des Messgerätes, insbesondere eine Warnmitteilung, an.

Bei einer weiteren möglichen Ausführungsform des erfindungsgemäßen Systems weist der Tastkopf eine integrierte Energieversorgungseinheit, insbesondere eine Batterie oder einen Akkumulator, zur Stromversorgung der Recheneinheit und/oder zur Stromversorgung der Anzeigeeinheit und/oder zur Stromversorgung des Messsignalverstärkers des Tastkopfes auf.

Bei einer weiteren möglichen Ausführungsform des erfindungsgemäßen Systems überwacht die Recheneinheit des Tastkopfes einen Betriebszustand der in dem Tastkopf enthaltenen Einheiten, insbesondere einen Betriebszustand der Anzeigeeinheit, einen Betriebszustand des Messsignalverstärkers und einen Betriebszustand der Energieversorgungseinheit des Tastkopfes. Bei einer weiteren möglichen Ausführungsform des erfindungsgemäßen Systems zeigt die Anzeigeeinheit des Tastkopfes einen kritischen Betriebszustand einer darin enthaltenen Einheit an.

Im Weiteren werden mögliche Ausführungsformen des erfindungsgemäßen Systems unter Bezugnahme auf die beigefügten Figuren näher erläutert.

Es zeigen:
- Fig. 1: ein erstes Ausführungsbeispiel eines nicht erfindungsgemäßen Systems mit einem Tastkopf, der direkt über eine Messsignalleitung mit einem Messgerät verbunden ist;
- Fig. 2: ein Ausführungsbeispiel für ein erfindungsgemäßes System mit einem Tastkopf, der über eine Tastkopfanschlusseinheit mit einem Messgerät verbunden ist.

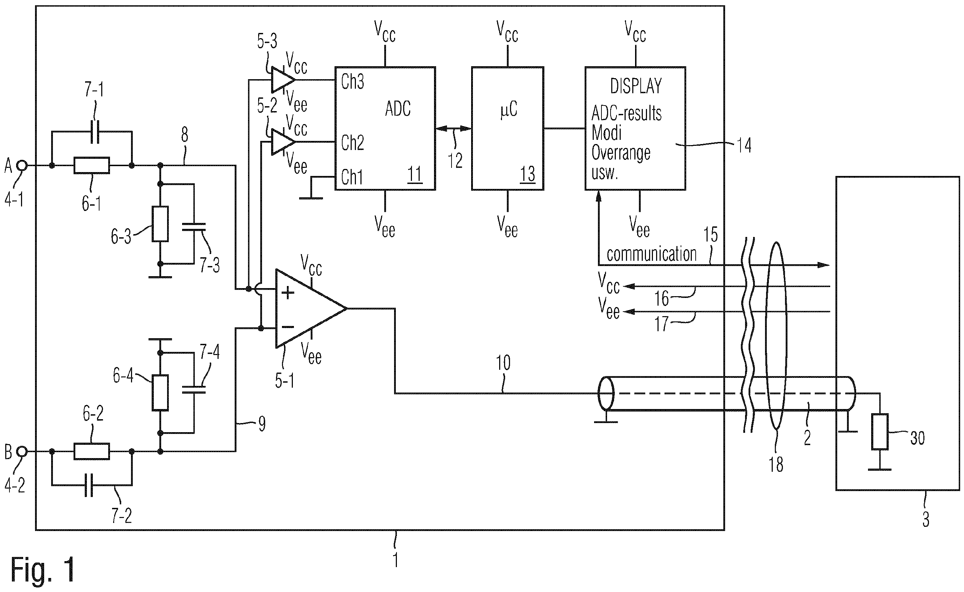

Wie man aus Fig. 1 erkennen kann, ist ein Tastkopf 1 bei dem dargestellten Ausführungsbeispiel über eine Messsignalleitung 2 direkt mit einem Messgerät 3 bzw. Grundgerät verbunden. Das Messgerät 3 ist beispielsweise ein Oszillograph oder ein Spektrumanalyzer. Der Tastkopf 1 weist mindestens eine Messspitze zur sensorischen Erfassung eines Signals, beispielsweise eines Spannungs- oder Stromsignals, auf. Bei dem in Fig. 1 dargestellten Ausführungsbeispiel besitzt der Tastkopf 1 zwei Messspitzen 4-1, 4-2. Der Tastkopf 1 besitzt ferner mindestens einen Messsignalverstärker zur Signalverstärkung des durch die Messspitze sensorisch erfassten Signals. Bei dem in Fig. 1 dargestellten Ausführungsbeispiel besitzt der Tastkopf 1 drei Messsignalverstärker 5-1, 5-2, 5-3, die jeweils ein Messsignal verstärken. Die Messsignalverstärker 5-1, 5-2, 5-3 können jeweils durch einen Operationsverstärker gebildet sein, der mit einer positiven und negativen Versorgungsspannung Vcc, Vee versorgt wird. Bei dem in Fig. 1 dargestellten Ausführungsbeispiel sind an den beiden Messspitzen 4-1, 4-2 jeweils ein Widerstand 6-1, 6-2 und ein dazu parallel verschalteter Kondensator 7-1, 7-2 vorgesehen. Diese dienen zur Einstellung eines Teilungsverhältnisses des Tastkopfes 1. Bei einer möglichen Ausführungsform kann für jede Messspitze 4-1, 4-2 ein weiteres Paar parallel geschalteter Widerstände und Kondensatoren vorgesehen sein, wie in Fig. 1 dargestellt. Die erste Messspitze 4-1 ist über eine interne Signalleitung 8 mit dem nicht invertierenden Eingang des Signalverstärkers 5-1 verbunden, wie in Fig. 1 dargestellt. Die zweite Messspitze 4-2 ist über eine weitere interne Signalleitung 9 mit dem invertierenden Eingang des ersten Messsignalverstärkers 5-1 verbunden. Ein weiterer Widerstand 6-3 und ein dazu parallel verschalteter Kondensator 7-3 sind zwischen der Leitung 8 und dem Referenzpotential, insbesondere Masse, verschaltet. In symmetrischer Weise ist zwischen der anderen internen Signalleitung 9 und einem Referenzpotential, insbesondere Masse, ein weiterer Widerstand 6-4 und ein dazu parallel geschalteter Kondensator 7-4 vorgesehen. Zwischen dem nicht invertierenden und dem invertierenden Eingang des ersten Messsignalverstärkers 5-1 liegt eine Differenzspannung zwischen der ersten Messspitze 4-1 und der zweiten Messspitze 4-2 an. Dieses Messsignal wird durch den Messsignalverstärker 5-1 verstärkt und über eine interne Signalleitung 10 an die Messsignalleitung 2, welche den Tastkopf 1 mit dem Messgerät 3 verbindet, geleitet, wie in Fig. 1 dargestellt. Der zweite Messsignalverstärker 5-2 greift das von der zweiten Messspitze 4-2 abgegebene Messsignal an einem Abzweigungspunkt der internen Leitung 9 ab und verstärkt dieses Signal. In gleicher Weise greift der dritte Messsignalverstärker 5-3 das von der ersten Messspitze 4-1 aufgenommene Messsignal an einem Abzweigungspunkt der internen Signalleitung 8 ab und gibt es verstärkt an einen in dem Tastkopf 1 integrierten Analog/Digital-Wandler 11 ab, wie in Fig. 1 dargestellt. Der Analog/Digital-Wandler 11 weist bei dem in Fig. 1 dargestellten Ausführungsbeispiel drei Kanäle CH1, CH2, CH3 auf. Dabei ist der erste Kanal CH1 mit einem Referenzpotential , insbesondere Masse, verbunden. Der zweite Kanal CH2 des Analog/Digital-Wandlers 11 empfängt das durch den zweiten Messsignalverstärker 5-2 verstärkte Messsignal und der dritte Kanal CH3 des Analog/Digital-Wandlers 11 erhält das von dem dritten Messsignalverstärker 5-3 verstärkte Messsignal. Demzufolge erhält der zweite Kanal CH2 des Analog/Digital-Wandlers 11 das von der zweiten Messspitze 4-2 abgegriffene Messsignal und der dritte Kanal CH3 des Analog/Digital-Wandlers 11 das von der ersten Messspitze 4-1 abgegriffene Messsignal. Die Kanäle CH1, CH2, CH3 sind vorzugsweise selektierbar, beispielsweise durch ein Steuersignal, welches eine Steuereinheit des Tastkopfes 1 von dem Messgerät 3 erhält. Der Analog/Digital-Wandler 11 wandelt das jeweilige erfasste analoge Messsignal in digitale Messwerte um. Diese Messwerte werden über eine Datenschnittstelle 12 einer internen Recheneinheit 13 des Tastkopfes 1 zugeführt, welche die Messwerte zur Anzeige auf einer Anzeigeeinheit 14 des Tastkopfes 1 aufbereitet. Der Tastkopf 1 besitzt bei dem in Fig. 1 dargestellten Ausführungsbeispiel eine Kommunikationsschnittstelle 15 zur Übertragung der digitalen Messwerte von der Recheneinheit 13 zu dem Messgerät 3. Die Messsignalverstärker 5-i, der Analog/Digital-Wandler 11, die Recheneinheit 13 sowie die Anzeigeeinheit 14 des Tastkopfes 1 werden jeweils mit einer Versorgungsspannung versorgt, wie in Fig. 1 dargestellt. Bei dem in Fig. 1 dargestellten Ausführungsbeispiel erhält der Tastkopf 1 eine positive Versorgunggsspannung Vcc und eine negative Versorgungsspannung Vee über entsprechende Stromversorgungsleitungen 16, 17 von dem Messgerät 3. Bei einer alternativen Ausführungsform kann der Tastkopf 1 auch über eine eigene Strom- bzw. Spannungsversorgungseinheit verfügen. Mindestens eine Datenleitung 15 zur Übertragung der Messwerte, die Messsignalleitung 2 zur Übertragung des sensorisch erfassten und verstärkten analogen Signals sowie die Stromversorgungsleitungen 16, 17 zur Stromversorgung der Recheneinheit 13, der Messsignalverstärker 5 sowie zur Stromversorgung der Anzeigeeinheit 14 sind bei einer möglichen Ausführungsform in einem Messkabel 18 enthalten, welches den Tastkopf 1 mit dem Messgerät 3 verbindet.

Bei einer möglichen Ausführungsform des Tastkopfes 1 weist der Tastkopf 1 eine Nutzerschnittstelle zur Eingabe von Benutzerbefehlen eines Nutzers, beispielsweise eines Messtechnikers, auf. Bei einer möglichen Ausführungsform ist die Anzeigeeinheit 14 ein Touchscreen, welches eine Nutzerschnittstelle für Benutzereingaben eines Nutzers bildet.

Bei einer möglichen Ausführungsform des Tastkopfes 1 weist die Kommunikationsschnittstelle 15 des Tastkopfes 1 eine bidirektionale Datenschnittstelle zum bidirektionalen Datenaustausch zwischen dem Tastkopf 1 und dem an den Tastkopf 1 angeschlossenen Messgerät 3 auf. Bei dieser Ausführungsform kann die Recheneinheit 13 des Tastkopfes 1 über die bidirektionale Datenschnittstelle 15 Betriebszustandsdaten von dem Messgerät erhalten, die einen aktuellen Betriebszustand des angeschlossenen Messgerätes 3 angeben. Weiterhin kann die Recheneinheit 13 des Tastkopfes 1 über die bidirektionale Datenschnittstelle 15 Mitteilungen und/oder Steuerbefehle des Messgerätes 3 erhalten. Die Mitteilungen bzw. Nachrichten kann das Messgerät 3 bei einer möglichen Ausführungsform in Abhängigkeit des über die Messsignalleitung 2 von dem Tastkopf 1 erhaltenen Messsignals generieren. Bei dem in Fig. 1 dargestellten Ausführungsbeispiel ist die Messsignalleitung 2 an einen Abschlusswiderstand 30 des Messgerätes 3 angeschlossen.

Die Anzeigeeinheit 14 des Tastkopfes 1 zeigt die von dem Analog/Digital-Wandler 11 generierten digitalen Messwerte an. Neben den Messwerten kann die Anzeigeeinheit 14 einen momentanen Betriebszustand des angeschlossenen Messgerätes 3 anzeigen. Weiterhin kann die Anzeigeeinheit 14 Mitteilungen anzeigen, welche der Tastkopf 1 über die bidirektionale Datenschnittstelle 15 von dem Messgerät 3 erhalten hat. Beispielsweise kann die Anzeigeeinheit 14 in dem in Fig. 1 dargestellten Ausführungsbeispiel des Tastkopfes 1 eine oder mehrere empfangene Warnmitteilungen des Messgerätes 3 anzeigen. Der Nutzer, der den Tastkopf 1 hantiert, kann somit unmittelbar an dem Tastkopf 1 eine Warnung erkennen, ohne auf eine Anzeigeeinheit des Messgerätes 3 blicken zu müssen.

Bei einer weiteren möglichen Ausführungsform überwacht die Recheneinheit 13 den Betriebszustand der in dem Tastkopf 1 enthaltenen Einheiten. Beispielsweise kann die Recheneinheit 13 bei einer möglichen Ausführungsform den Betriebszustand der Messsignalverstärker 5-i, der Anzeigeeinheit 14, des Analog/Digital-Wandlers 11 sowie den eigenen Betriebszustand überwachen. Bei einer möglichen Ausführungsform wird der von der Recheneinheit 13 überwachte Betriebszustand der Einheiten auf der lokalen Anzeigeeinheit 14 des Tastkopfes 1 dem Nutzer bzw. Messtechniker angezeigt. Bei einer möglichen Ausführungsform besitzt der Tastkopf 1 eine integrierte Energieversorgungseinheit, beispielsweise eine Batterie oder einen Ackumulator zur Stromversorgung der übrigen in dem Tastkopf 1 integrierten Einheiten, insbesondere der Messsignalverstärker 5-i, des Analog/Digital-Wandlers 11, der Recheneinheit 13 sowie der Anzeigeeinheit 14. Bei dieser Ausführungsform kann die Anzeigeeinheit 14 den Betriebszustand der Energieversorgungseinheit bzw. den Ladezustand dem Nutzer anzeigen, sodass dieser beispielsweise rechtzeitig eine Batterie auswechseln kann. Die lokale Anzeigeeinheit 14 des Tastkopfes 1 kann insbesondere eine bei der Messung erfasste Überspannung unmittelbar dem Nutzer anzeigen, sodass dieser rechtzeitig die Messspitze von der betreffenden Messstelle abheben kann. Die Anzeigeeinheit 14 kann ferner unterschiedliche Betriebszustände oder Messparameter dem Nutzer anzeigen, beispielsweise eine Akquisitionsrate, ein Trigger-Level, eine Dezimierung oder eine Vertikal-/Horizontalskalierung. Ferner kann die Anzeigeeinheit 14 verschiedenartige Messwerte anzeigen, beispielsweise MarkerWerte, Signalmittelwerte, Spannungspeak-Werte, VMS-Frequenz usw. Darüber hinaus kann die Anzeigeeinheit 14 Warn- bzw. Hilfsmitteilungen des Messgerätes 3 anzeigen. Weiterhin kann die Anzeigeeinheit 14 beispielsweise eine auftretende Übersteuerung, ein Teilungsverhältnis, eine Offset-Einstellung, einen Messmodus, insbesondere single-ended, differentiell oder Common Mode dem Nutzer bzw. Messtechniker während der Vornahme der Messung unmittelbar anzeigen. Während der Vornahme der Messung, beispielsweise an einer Platine, kann sich der Messtechniker voll auf die Messung konzentrieren, ohne auf eine Anzeigeeinheit des Messgerätes 3 blicken zu müssen.

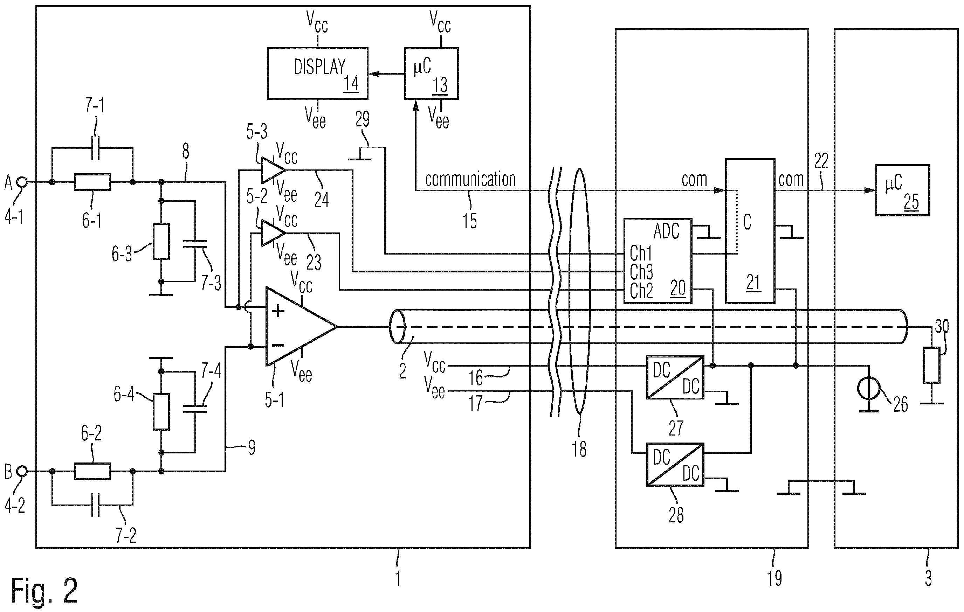

Fig. 2 zeigt ein weiteres Ausführungsbeispiel eines erfindungsgemäßen Systems mit einem Tastkopf 1 für ein Messgerät 3. Bei dem in Fig. 2 dargestellten Ausführungsbeispiel ist der Tastkopf 1 nicht direkt mit dem Messgerät 3 verbunden, sondern über eine Tastkopfanschlusseinheit (Probe Box) 19. Bei dem in Fig. 2 dargestellten Ausführungsform erfolgt die Analog/DigitalWandlung der Messsignale nicht im Tastkopf 1, sondern durch einen Analog/Digital-Wandler 20 der Tastkopfanschlusseinheit 19. Der Analog/Digital-Wandler 20 der Tastkopfanschlusseinheit 19 wandelt erhaltene Messsignale in Messwerte um und gibt diese an eine in der Tastkopfanschlusseinheit 19 enthaltene zweite Recheneinheit 21 ab. Die Recheneinheit 21 überträgt die Messwerte, welche sie von dem Analog/Digital-Wandler 20 erhält, bei einer möglichen Ausführungsform an das Messgerät 3 über eine Datenschnittstelle 22. Ferner kann die Recheneinheit 21 der Tastkopfanschlusseinheit 19 die Messwerte über die bidirektionale Kommunikationsschnittstelle 15 an die in dem Tastkopf 1 enthaltene Recheneinheit 13 übertragen. Bei dem in Fig. 2 dargestellten Ausführungsbeispiel gelangt das Ausgangssignal des Messsignalverstärkers 5-2 über eine Datenleitung 23 an den zweiten Eingangskanal CH2 des Analog/Digital-Wandlers 20, welcher das empfangende analoge Messsignal in entsprechende digitale Messwerte umwandelt und an die Recheneinheit bzw. den Mikrocontroller 21 der Tastkopfanschlusseinheit 19 abgibt. Das verstärkte Messsignal des dritten Messsignalverstärkers 5-3 wird über eine Leitung 24 an den dritten Eingangskanal CH3 des Analog/Digital-Wandlers 20 übertragen, der das empfangene analoge Messsignal in digitale Messwerte umwandelt und an die Recheneinheit bzw. den Mikrocontroller 21 der Tastkopfanschlusseinheit 19 ausgibt. Die auf dem zweiten Eingangskanal CH2 und dritten Eingangskanal CH3 des Analog/Digital-Wandlers 20 empfangenen Messsignale werden somit in Messwerte umgewandelt, welche von dem Mikrocontroller 21 der Tastkopfanschlusseinheit 19 weiterarbeitet werden können und/oder über Datenschnittstellen weitergeleitet werden. Die analog/digital gewandelten Messwerte werden beispielsweise über eine Datenschnittstelle 22 an eine Datenverarbeitungseinheit bzw. einen Prozessor 25 innerhalb des Messgerätes 3 übertragen, welcher die Messwerte auswertet und die Messergebnisse beispielsweise auf einer Anzeigeeinheit des Messgerätes 3 anzeigt. Weiterhin können die analog/digital gewandelten Messwerte von der Recheneinheit bzw. dem Mikrocontroller 21 der Tastkopfanschlusseinheit 19 über die bidirektionale Kommunikationsschnittstelle 15 von der Tastkopfanschlusseinheit 19 zurück zu der in dem Tastkopf 1 enthaltenen ersten Recheneinheit 13 übertragen werden. Die Recheneinheit 13 kann bei einer möglichen Ausführungsform die über die Datenschnittstelle 15 erhaltenen Messwerte aufbereiten und auf einer Anzeigeeinheit 14 des Tastkopfes 1 dem Messtechniker anzeigen.

Bei dem in Fig. 2 dargestellten Ausführungsbeispiel verfügt das Messgerät 3 über eine Spannungsquelle 26, welche eine Spannung an einen DC/DC-Wandler 27 innerhalb der Tastkopfanschlusseinheit 19 liefert. Der DC/DC-Wandler 27 erzeugt eine erste positive Versorgungsspannung V_{cc}, welche über eine Spannungsversorgungsleitung 16 dem Tastkopf 1 zur Spannungsversorgung der darin enthaltenen aktiven Einheiten liefert. Weiterhin kann das Messgerät 3 sowie die Tastkopfanschlusseinheit 19 ein gemeinsames Referenzpotential, insbesondere Masse bzw. Erde aufweisen, wie in Fig. 2 dargestellt. Ein in der Tastkopfanschlusseinheit 19 enthaltener zweiter DC/DC-Wandler 28 liefert bei dem dargestellten Ausführungsbeispiel eine zweite negative Versorgungsspannung Vee, die über eine Spannungsversorgungsleitung 17 dem Tastkopf 1 zugeführt wird.

Wie in Fig. 2 dargestellt, kann der Analog/Digital-Wandler 20 sowie der Mikrocontroller 21 der Tastkopfanschlusseinheit 19 durch die Spannungsversorgungseinheit 26 des Messgerätes 3 mit Spannung versorgt werden.

Wie man in Fig. 2 erkennen kann, umfasst das Messkabel 18 neben der Messsignalleitung 2 und den beiden Spannungsversorgungsleitungen 16, 17 die Datenleitungen 15, 23, 24. Weiterhin kann eine weitere Leitung 29 ein Referenzpotential des Tastkopfes 1 an einen ersten Eingangskanal CH1 des Analog/Digital-Wandlers über das Messkabel 18 anlegen.

Die Figuren 1, 2 zeigen zwei beispielhafte Ausführungsformen des Tastkopfes 1. Weitere Ausführungsvarianten des Tastkopfes sind möglich. Beispielsweise kann die Anzahl der Messspitzen 4-i je nach Anwendungsfall variieren. Auch die Anzahl der in dem Tastkopf 1 enthaltenen Messsignalverstärker sowie die Eingangskanäle CH des Analog/DigitalWandlers kann variieren. Auch Zwischenformen bzw. Kombinationen der beiden in den Figuren 1, 2 dargestellten Ausführungsformen sind möglich. Beispielsweise kann sowohl der Tastkopf 1 als auch die Tastkopfanschlusseinheit 19 jeweils einen Analog/Digital-Wandler aufweisen. Die Messsignalleitung 2 zur Übertragung des analogen Messsignals von dem Tastkopf 1 zu dem Messgerät 3 ist vorzugsweise eine geschirmte Signalleitung. Diese Signalleitung 2 kann in einem Messkabel 18 enthalten sein, wie in den beiden Ausführungsformen gemäß Figuren 1 und 2 dargestellt ist.

Bei einer möglichen Ausführungsform werden dem Tastkopf 1 auch Informationen und Anweisungen zur Vornahme des Testvorganges durch den Messtechniker übertragen. Beispielsweise kann in einem konfigurierbaren Speicher des Messgerätes 3 ein Messprotokoll zur Vornahme einer Folge von Messungen an einem bestimmten Gerät oder einer bestimmten Platine abgelegt sein.

Dieses Messprotokoll enthält Anweisungen für einen Messtechniker zur Vornahme bestimmter Messvorgänge an dem zu untersuchenden Gerät. Bei einer möglichen Ausführungsform werden über die bidirektionale Datenschnittstelle 15 diese Anweisungen und/oder Informationen hinsichtlich des Messvorganges an den Tastkopf 1 sequentiell übertragen und dort auf der Anzeigeeinheit 14 dem Messtechniker angezeigt. Beispielsweise wird einem Messtechniker zunächst angezeigt, die erste Messspitze 4-1 an einen ersten Messpunkt zu legen und anschließend nach dem dieser erste Messchritt abgeschlossen ist wird der Messtechniker aufgefordert, die zweite Messspitze 4-2 auf einen anderen Messpunkt des zu untersuchenden Gerätes zu setzen. Über die Nutzerschnittstelle des Tastkopfes 1 kann der Messtechniker die Beendigung des jeweiligen Messchrittes dem Messgerät 3 bestätigen. Bei einer weiteren möglichen Ausführungsform wird über die mindestens eine Messspitze 4-i des Tastkopfes 1 ein Identifizierungssignal des zu untersuchenden Gerätes an eine Datenverarbeitungseinheit des Messgerätes 3 übertragen, welche daran einen Bautyp des auszumessenden Gerätes erkennt und entsprechende Messbefehle an den Tastkopf 1 zurücküberträgt, die auf der Anzeigeeinheit 14 des Tastkopfes 1 dem Messtechniker optisch angezeigt werden. Weiterhin kann das Messgerät 3 den Messtechniker auf Sicherheitsrisiken bei Vornahme von Messungen an dem identifizierten Gerät aufmerksam machen. Bei der Anzeigeeinheit 14 des Tastkopfes 1 kann es sich bei einer möglichen Ausführungsform auch um ein Farbdisplay handeln, welches insbesondere kritische Warnmeldungen in einer besonderen Farbe, beispielsweise rot, anzeigt. Bei einer weiteren möglichen Ausführungsform besitzt der Tastkopf 1 zusätzlich einen integrierten Lautsprecher, um Warnmeldungen zusätzlich akustisch anzuzeigen. Der Tastkopf 1 ist vorzugsweise in einem elektrisch isolierenden Gehäuse integriert.

## Patentansprüche

1. System umfassend:
- einen Tastkopf (1) für ein Messgerät (3); und
- eine Tastkopfanschlusseinheit (19),
wobei der Tastkopf (1) folgendes umfasst:
(a) mindestens eine Messspitze (4) zur sensorischen Erfassung eines Signals; und
(b) mindestens einen Messsignalverstärker (5) zur Signalverstärkung des durch die Messspitze (4) sensorisch erfassten Signals, wobei der Messsignalverstärker (5) dazu eingerichtet ist, das verstärkte Messsignal über mindestens eine Messsignalleitung (2) eines Messkabels an die Tastkopfanschlusseinheit (19) und/oder an das Messgerät (3) zu übertragen;
wobei die Tastkopfanschlusseinheit (19) des Tastkopfes (1) einen Analog/Digital-Wandler aufweist (20), der dazu eingerichtet ist, ein von einem Messsignalverstärker (5) des Tastkopfes (1) verstärktes und über eine Signalleitung (23, 24) übertragenes Messsignal in digitale Messwerte umzuwandeln,
**dadurch gekennzeichnet, dass**
der Tastkopf (1) ferner folgendes umfasst:
eine Anzeigeeinheit (14); und
eine Recheneinheit (13), die dazu eingerichtet ist, die Messwerte des durch die Messspitze (4) erfassten Signals zur Anzeige auf der Anzeigeeinheit (14) des Tastkopfes (1) aufzubereiten; und
die Tastkopfanschlusseinheit (19) ferner eine Recheneinheit (21) umfasst, die dazu eingerichtet ist, die vom Analog/Digital-Wandler ausgegebenen Messwerte an die Recheneinheit (13) des Tastkopfes (1) und an das Messgerät (3) zu übertragen.

2. System nach Anspruch 1,
wobei der Tastkopf (1) eine Nutzerschnittstelle für Benutzereingaben eines Nutzers aufweist.

3. System nach Anspruch 2,
wobei die Anzeigeeinheit (14) ein Touchscreen ist, das eine Nutzerschnittstelle für Benutzereingaben eines Nutzers bildet.

4. System nach einem der vorangehenden Ansprüche 1 bis 3, wobei der Tastkopf (1) eine weitere Messspitze zur sensorischen Erfassung eines Referenzpotentials aufweist.

5. System nach einem der vorangehenden Ansprüche 1 bis 4, wobei die Recheneinheit (13) und/oder die Anzeigeeinheit (14) und/oder der Messsignalverstärker (5) des Tastkopfes (1) über mindestens eine Stromversorgungsleitung (16, 17) von der Tastkopfanschlusseinheit (19) mit Strom versorgt werden.

6. System nach einem der vorangehenden Ansprüche 1 bis 5, wobei Datenleitungen einer Kommunikationsschnittstelle (15) für die Übertragung der Messwerte, die Messsignalleitung (2) für die Übertragung des sensorisch erfassten und verstärkten Signals sowie die Stromversorgungsleitungen (16, 17) zur Stromversorgung der Recheneinheit (13) und/oder zur Stromversorgung des Messsignalverstärkers (5) und/oder zur Stromversorgung der Anzeigeeinheit (14) in einem Messkabel (18) enthalten sind.

7. System nach Anspruch 1,
wobei der Tastkopf (1) eine Kommunikationsschnittstelle (15) umfasst, die eine bidirektionale Datenschnittstelle zum bidirektionalen Datenaustausch zwischen dem Tastkopf (1) und der daran angeschlossenen Tastkopfanschlusseinheit (19) aufweist.

8. System nach Anspruch 7,
wobei die Recheneinheit (13) des Tastkopfes (1) dazu eingerichtet ist, über die bidirektionale Datenschnittstelle Betriebszustandsdaten zu erhalten, die einen aktuellen Betriebszustand des angeschlossenen Messgerätes (3) angeben und/oder Mitteilungen des Messgerätes (3) erhält, die das Messgerät (3) in Abhängigkeit des über die Messsignalleitung (2) von dem Tastkopf (1) erhaltenen Messsignals generiert.

9. System nach Anspruch 8,
wobei die Anzeigeeinheit (14) des Tastkopfes (1) neben Messwerten des von der Messspitze (4) des Tastkopfes (1) sensorisch erfassten Signals, einen Betriebszustand des angeschlossenen Messgerätes (3) und/oder eine erhaltene Mitteilung des Messgerätes (3), insbesondere eine Warnmitteilung, anzeigt.

10. System nach einem der vorangehenden Ansprüche 1 bis 9, wobei der Tastkopf (1) eine integrierte Energieversorgungseinheit, insbesondere eine Batterie oder einen Akkumulator, zur Stromversorgung der Recheneinheit (13) und/oder der Anzeigeeinheit (14) und/oder des Messsignalverstärkers (5) aufweist.

11. System nach einem der vorangehenden Ansprüche 1 bis 10, wobei die Recheneinheit (13) des Tastkopfes (1) einen Betriebszustand der in dem Tastkopf (1) enthaltenen Einheiten, insbesondere den Betriebszustand der Anzeigeeinheit (14), des Messsignalverstärkers (5) und der Energieversorgungseinheit überwacht.

12. System nach Anspruch 11,
wobei die Anzeigeeinheit (14) des Tastkopfes (1) einen Betriebszustand einer in dem Tastkopf (1) enthaltenen Einheit, insbesondere einen kritischen Betriebszustand der Einheit, anzeigt.

13. System nach einem der vorangehenden Ansprüche 1-12, ferner umfassend ein Messgerät (3), das über die Tastkopfanschlusseinheit (19) an den Tastkopf (1) anschließbar ist.

14. System nach Anspruch 13,
wobei das Messgerät (3) ein Oszilloskop oder ein Spektrumanalyzer ist.

## Claims

1. System comprising:
- a probe (1) for a measuring device (3); and
- a probe connection unit (19),
the probe (1) comprising the following:
(a) at least one measuring tip (4) for sensing a signal; and
(b) at least one measuring signal amplifier (5) for signal amplification of the signal sensed by the measuring tip (4), the measuring signal amplifier (5) being designed to transmit the amplified measuring signal via at least one measuring signal line (2) of a measuring cable to the probe connection unit (19) and/or the measuring device (3);
the probe connection unit (19) of the probe (1) having an analog-to-digital converter (20) which is designed to convert a measuring signal, amplified by a measuring signal amplifier (5) of the probe (1) and transmitted via a signal line (23, 24), into digital measured values,
**characterized in that**
the probe (1) further comprises the following:
a display unit (14); and
a computing unit (13) which is designed to prepare the measured values of the signal detected by the measuring tip (4) for display on the display unit (14) of the probe (1); and
the probe connection unit (19) further comprises a computing unit (21) which is designed to transmit the measured values output by the analog-to-digital converter to the computing unit (13) of the probe (1) and to the measuring device (3).

2. System according to claim 1,
wherein the probe (1) has a user interface for user input of a user.

3. System according to claim 2,
wherein the display unit (14) is a touch screen which forms a user interface for user input of a user.

4. System according to any of the preceding claims 1 to 3, wherein the probe (1) has a further measuring tip for sensing a reference potential.

5. System according to any of the preceding claims 1 to 4, wherein the computing unit (13) and/or the display unit (14) and/or the measuring signal amplifier (5) of the probe (1) are supplied with power via at least one power supply line (16, 17) by the probe connection unit (19).

6. System according to any of the preceding claims 1 to 5, wherein data lines of a communication interface (15) for transmitting the measured values, the measuring signal line (2) for transmitting the sensed and amplified signal, and the power supply lines (16, 17) for supplying power to the computing unit (13) and/or for supplying power to the measuring signal amplifier (5) and/or for supplying power to the display unit (14) are contained in a measuring cable (18).

7. System according to claim 1,
wherein the probe (1) comprises a communication interface (15) which has a bidirectional data interface for bidirectional data exchange between the probe (1) and the probe connection unit (19) connected thereto.

8. System according to claim 7,
wherein the computing unit (13) of the probe (1) is designed to receive operating state data via the bidirectional data interface, which data indicate a current operating state of the connected measuring device (3), and/or receives messages from the measuring device (3), which the measuring device (3) generates depending on the measuring signal received from the probe (1) via the measuring signal line (2).

9. System according to claim 8,
wherein the display unit (14) of the probe (1) displays, in addition to measured values of the signal sensed by the measuring tip (4) of the probe (1), an operating state of the connected measuring device (3) and/or a received message from the measuring device (3), in particular a warning message.

10. System according to any of the preceding claims 1 to 9, wherein the probe (1) has an integrated power supply unit, in particular a battery or an accumulator, for supplying power to the computing unit (13) and/or the display unit (14) and/or the measuring signal amplifier (5).

11. System according to any of the preceding claims 1 to 10, wherein the computing unit (13) of the probe (1) monitors an operating state of the units contained in the probe (1), in particular the operating state of the display unit (14), of the measuring signal amplifier (5), and of the power supply unit.

12. System according to claim 11,
wherein the display unit (14) of the probe (1) displays an operating state of a unit contained in the probe (1), in particular a critical operating state of the unit.

13. System according to any of the preceding claims 1 to 12, further comprising a measuring device (3) which can be connected to the probe (1) via the probe connection unit (19).

14. System according to claim 13, wherein the measuring device (3) is an oscilloscope or a spectrum analyzer.

## Revendications

1. Système comprenant :
- une tête de palpage (1) pour un appareil de mesure (3) ; et
- une unité de connexion de tête de palpage (19),
dans lequel la tête de palpage (1) comprend les éléments suivants :
(a) au moins une pointe de mesure (4) pour la détection par capteur d'un signal ; et
(b) au moins un amplificateur de signal de mesure (5) pour l'amplification de signal du signal détecté par capteur par la pointe de mesure (4), dans lequel l'amplificateur de signal de mesure (5) est configuré pour transmettre le signal de mesure amplifié à l'unité de connexion de tête de palpage (19) et/ou à l'appareil de mesure (3) par l'intermédiaire d'au moins une ligne de signal de mesure (2) d'un câble de mesure ;
dans lequel l'unité de connexion de tête de palpage (19) de la tête de palpage (1) présente un convertisseur analogique-numérique (20) qui est configuré pour convertir un signal de mesure amplifié par un amplificateur de signal de mesure (5) de la tête de palpage (1) et transmis par l'intermédiaire d'une ligne de signal (23, 24) en valeurs de mesure numériques,
**caractérisé en ce que**
la tête de palpage (1) comprend en outre les éléments suivants :
une unité d'affichage (14) ; et
une unité de calcul (13) qui est configurée pour traiter les valeurs de mesure du signal détecté par la pointe de mesure (4) pour leur affichage sur l'unité d'affichage (14) de la tête de palpage (1) ; et
l'unité de connexion de tête de palpage (19) comprend en outre une unité de calcul (21) qui est configurée pour transmettre les valeurs de mesure délivrées en sortie par le convertisseur analogique-numérique à l'unité de calcul (13) de la tête de palpage (1) et à l'appareil de mesure (3).

2. Système selon la revendication 1,
dans lequel la tête de palpage (1) présente une interface utilisateur pour des entrées utilisateur d'un utilisateur.

3. Système selon la revendication 2,
dans lequel l'unité d'affichage (14) est un écran tactile qui forme une interface utilisateur pour des entrées utilisateur d'un utilisateur.

4. Système selon l'une des revendications précédentes 1 à 3, dans lequel la tête de palpage (1) présente une pointe de mesure supplémentaire pour la détection par capteur d'un potentiel de référence.

5. Système selon l'une des revendications précédentes 1 à 4, dans lequel l'unité de calcul (13) et/ou l'unité d'affichage (14) et/ou l'amplificateur de signal de mesure (5) de la tête de palpage (1) sont alimentés en courant par l'unité de connexion de tête de palpage (19) par l'intermédiaire d'au moins une ligne d'alimentation en courant (16, 17).

6. Système selon l'une des revendications précédentes 1 à 5, dans lequel des lignes de données d'une interface de communication (15) pour la transmission des valeurs de mesure, la ligne de signal de mesure (2) pour la transmission du signal détecté par capteur et amplifié, ainsi que les lignes d'alimentation en courant (16, 17) pour l'alimentation en courant de l'unité de calcul (13) et/ou pour l'alimentation en courant de l'amplificateur de signal de mesure (5) et/ou pour l'alimentation en courant de l'unité d'affichage (14) sont contenues dans un câble de mesure (18).

7. Système selon la revendication 1,
dans lequel la tête de palpage (1) comprend une interface de communication (15) qui présente une interface de données bidirectionnelle pour l'échange de données bidirectionnel entre la tête de palpage (1) et l'unité de connexion de tête de palpage (19) connectée à celle-ci.

8. Système selon la revendication 7,
dans lequel l'unité de calcul (13) de la tête de palpage (1) est configurée pour recevoir, par l'intermédiaire de l'interface de données bidirectionnelle, des données d'état de fonctionnement qui indiquent un état de fonctionnement actuel de l'appareil de mesure (3) connecté, et/ou reçoit des messages de l'appareil de mesure (3) que l'appareil de mesure (3) génère en fonction du signal de mesure reçu en provenance de la tête de palpage (1) par l'intermédiaire de la ligne de signal de mesure (2).

9. Système selon la revendication 8,
dans lequel l'unité d'affichage (14) de la tête de palpage (1) affiche, outre des valeurs de mesure du signal détecté par capteur par la pointe de mesure (4) de la tête de palpage (1), un état de fonctionnement de l'appareil de mesure (3) connecté et/ou un message reçu de l'appareil de mesure (3), en particulier un message d'avertissement.

10. Système selon l'une des revendications précédentes 1 à 9, dans lequel la tête de palpage (1) présente une unité d'alimentation en énergie intégrée, en particulier une batterie ou un accumulateur, pour l'alimentation en courant de l'unité de calcul (13) et/ou de l'unité d'affichage (14) et/ou de l'amplificateur de signal de mesure (5).

11. Système selon l'une des revendications précédentes 1 à 10, dans lequel l'unité de calcul (13) de la tête de palpage (1) surveille un état de fonctionnement des unités contenues dans la tête de palpage (1), en particulier l'état de fonctionnement de l'unité d'affichage (14), de l'amplificateur de signal de mesure (5) et de l'unité d'alimentation en énergie.

12. Système selon la revendication 11,
dans lequel l'unité d'affichage (14) de la tête de palpage (1) affiche un état de fonctionnement d'une unité contenue dans la tête de palpage (1), en particulier un état de fonctionnement critique de l'unité.

13. Système selon l'une des revendications précédentes 1 à 12, comprenant en outre un appareil de mesure (3) qui peut être connecté à la tête de palpage (1) par l'intermédiaire de l'unité de connexion de tête de palpage (19).

14. Système selon la revendication 13, dans lequel l'appareil de mesure (3) est un oscilloscope ou un analyseur de spectre.
